# EUROPÄISCHE PATENTANMELDUNG

(11) **EP 1 694 107 A1**
(43) Veröffentlichungstag der Anmeldung: **23.08.2006**
(21) Anmeldenummer: 05003455.2
(22) Anmeldetag: 17.02.2005
(51) Int. Cl.: H05K 13/02, H05K 13/04

(54) **Vorrichtung und Verfahren zur Aufnahme und Übergabe eines elektronischen Bauteils**

(71) Anmelder: KLARER, Christoph, D-82024 Taufkirchen (DE)
(72) Erfinder: KLARER, Christoph, D-82024 Taufkirchen (DE)
(74) Vertreter: Hofstetter, Alfons J.

(57) **Zusammenfassung**

Die vorliegende Erfindung betrifft eine Vorrichtung zur Aufnahme und Übergabe von elektronischen Bauteilen auf ein Bauteilereservoir, insbesondere eine vollautomatische Aufnahme- und Übergabevorrichtung zur Herstellung mikrosystemtechnischer Produkte sowie für Montageaufgaben in der Halbleiterindustrie, mit einem ersten Bauteilereservoir (39), welches auf einem ersten Montagetisch (31 c) angeordnet ist und einem zweiten Bauteilereservoir (49), welches auf einem zweiten Montagetisch (41 c) angeordnet ist, wobei in dem ersten Bauteilereservoir (39) elektronische Bauteile für das zweite Bauteilereservoir (49) bereitgestellt sind, und die Vorrichtung eine Aufnahme- und Transporteinheit (6) zur Aufnahme der elektronischen Bauteile aus dem ersten Bauteilereservoir (39) und zum Transport der elektronischen Bauteile von dem ersten Bauteilereservoir (39) zum zweiten Bauteilereservoir (49) aufweist, und ein optisches System (7) umfasst, welches zur Überwachung einer Aufnahmeposition von elektronischen Bauteilen aus dem ersten Bauteilereservoir (39) und zur Überwachung der Montageposition der aufgenommenen elektronischen Bauteile in dem zweiten Bauteilereservoir (49) ausgebildet ist.

## Beschreibung

Die vorliegende Erfindung betrifft eine Vorrichtung sowie ein Verfahren zur Aufnahme und Übergabe eines elektronischen Bauteils.

Insbesondere betrifft die Erfindung eine vollautomatische Aufnahme- und Übergabevorrichtung zur Herstellung mikrosystemtechnischer Produkte sowie für Montageaufgaben in der Halbleiterindustrie. Des Weiteren betrifft die vorliegende Erfindung ein Verfahren zur Aufnahme und Übergabe von Bauteilen, insbesondere mit einer vollautomatischen Aufnahme- und Übergabevorrichtung zur Herstellung mikrosystemtechnischer Produkte.

Vorrichtungen und Verfahren zur Montage von Bauteilen im mikrosystemtechnischen Bereich sind in vielfacher Weise bekannt. Ein wesentliches Anforderungskriterium an derartige Vorrichtungen zur Montage von Halbleiter- und Mikrosystembauteilen besteht darin, dass eine sehr hohe Platziergenauigkeit der Bauteile und zusätzlich eine hohe Durchsatzzahl erreicht werden muss. Wesentliche Einflussfaktoren auf diese Anforderungskriterien sind zum Einen die zunehmende Miniaturisierung der Bauteile, eine steigende Bauteilfunktionalität mit dadurch steigender Zahl der externen, insbesondere der elektrischen Anschlüsse sowie funktionsbedingte Präzisionsanforderungen.

Insbesondere für Montagevorrichtungen, bei denen die benötigten und erforderlichen elektronischen Bauteile aus Bauteilereservoirs ausgewählt und übergeben werden, sind sehr hohe Anforderungen gestellt. Aus DE 201 03 184 U1 ist eine Aufnahme- und Übergabevorrichtung bekannt, welche ein Aufnahmewerkzeug aufweist und zur Aufnahme eines Bauteils von einem Bauteilereservoir und zur Übergabe des aufgenommenen Bauteils an ein Montagewerkzeug ausgebildet ist. Die Aufnahme- und Übergabevorrichtung weist des Weiteren ein optisches System zur Aufnahme und Bestimmung einer Relativlage des aufzunehmenden Bauteils auf. Mittels dem optischen System kann die Relativlage des von dem im Aufnahmekopf angeordneten Aufnahmewerkzeugs aufgenommen Bauteils vor der Übergabe an das Montagewerkzeug bestimmt werden. Des Weiteren ist es mit der entsprechenden Anordnung möglich, dass während einer Drehung des Aufnahmekopfs mit dem aufgenommenen Bauteil der Aufnahmekopf aus einer optischen Achse des optischen Systems ausgeschwenkt ist und so eine zeitgleiche Aufnahme und Bestimmung einer Relativlage eines nachfolgend durch den Aufnahmekopf aufzunehmenden Bauteils aus dem Bauteilereservoir ermöglicht wird.

Eine weitere Vorrichtung zur Montage von Bauteilen ist aus EP 1 235 474 A1 bekannt. Die Vorrichtung ist als vollautomatische Montagevorrichtung zur Herstellung mikrosystemtechnischer Produkte sowie für Montageaufgaben in der Halbleiterindustrie ausgebildet. Die Vorrichtung weist einen Montagetisch und eine auf dem Montagetisch bewegbar angeordnete Bauteiletransporteinheit auf. Des Weiteren umfasst die Vorrichtung ein Materialtransportsystem zum Transport der mit Bauteilen zu bestückenden Produkte. Ein Montagekopf umfasst ein Transport- und Montagewerkzeug, wobei der Montagekopf an einem quer zur Bewegungsrichtung der Bauteiltransporteinheit bewegbaren ersten Schlitten der Bauteiltransporteinheit angeordnet ist. Darüber hinaus weist die Vorrichtung eine Mess-Station zur Bestimmung der Relativlage eines von dem Transport- und Montagewerkzeug aufgenommenen Bauteils zum Transport- und Montagewerkzeug auf. Die Mess-Station ist derart bewegbar angeordnet, dass das Transport- und Montagewerkzeug mit dem aufgenommenen Bauteil zwischen einer Bauteilaufnahmeposition und einer Bauteilablageposition die Mess-Station überfährt. Ein Nachteil der bekannten Vorrichtungen ist darin zu sehen, dass das Aufnehmen und Übergeben bzw. das Ablegen auf einer entsprechenden Bauteilablageposition relativ lange dauert. Lediglich während dem Transport des aufgenommenen Bauteils wird eine Bestimmung der Relativlage des Bauteils ermittelt, welches für einen nachfolgenden Positioniervorgang bzw. für einen nachfolgenden Vorgang zum entsprechenden Aufnehmen eines Bauteils herangezogen werden kann. Es wird jedoch keine Information dahingehend gewonnen, wie entsprechende Bauteilaufnahmepositionen und Bauteilablagepositionen zu finden sind und wie diese besetzt sind oder besetzt werden können. Ein wesentlicher Nachteil der dadurch entsteht, ist eine relativ geringe Durchsatzzahl, wodurch sich hohe Montagekosten für die Bauteile ergeben.

Daher ist es Aufgabe der vorliegenden Erfindung, eine Vorrichtung und ein Verfahren zur Montage von elektronischen Bauteilen auf ein Bauteilereservoir zu schaffen, mit dem ein hoher Bauteiledurchsatz gewährleistet werden kann und die Montagekosten für die Bauteile reduziert werden können. Darüber hinaus ist es Aufgabe der Erfindung, eine möglichst sichere und präzise Montage der Bauteile gewährleisten zu können und die Aufnahme sowie die Ablage bzw. die Montage der Bauteile schnell und zielsicher durchführen zu können.

Diese Aufgabe wird durch eine Vorrichtung, welche die Merkmale nach Patentanspruch 1 aufweist, und ein Verfahren, welches die Merkmale nach Patentanspruch 13 aufweist, gelöst.

Eine erfindungsgemäße Vorrichtung ist zur Aufnahme und Übergabe eines elektronischen Bauteils auf ein Bauteilereservoir ausgebildet. Die erfindungsgemäße Vorrichtung ist insbesondere als eine vollautomatische Aufnahme- und Übergabevorrichtung zur Herstellung mikrosystemtechnischer Produkte sowie für Montageaufgaben in der Halbleiterindustrie ausgelegt. Erfindungsgemäß umfasst die Vorrichtung ein erstes Bauteilereservoir, welches auf einem Montagetisch angeordnet ist. Des Weiteren umfasst die Vorrichtung ein zweites Bauteilereservoir, welches auf einem zweiten Montagetisch angeordnet ist und auf dem elektronische Bauteile, welche in dem ersten Bauteilereservoir bereitgestellt werden, montiert werden. Die erfindungsgemäße Vorrichtung umfasst weiterhin eine Aufnahme- und Transporteinheit zur Aufnahme der elektronischen Bauteile aus dem ersten Bauteilereservoir und zum Transport der elektronischen Bauteile von dem ersten Bauteilereservoir zum zweiten Bauteilereservoir. Als ein weiteres wesentliches Element der erfindungsgemäßen Vorrichtung ist ein optisches System vorgesehen, welches zur Überwachung einer Aufnahmeposition von elektronischen Bauteilen aus dem ersten Bauteilereservoir und zur Überwachung einer Montageposition der aufgenommenen elektronischen Bauteile in dem zweiten Bauteilereservoir ausgebildet ist. Mittels der erfindungsgemäßen Vorrichtung kann erreicht werden, dass relativ hohe Bauteildurchsatzzahlen und dadurch reduzierte Montagekosten für die Bauteile erreicht werden können. Darüber hinaus kann ermöglicht werden, dass das Aufnehmen, Transportieren und Ablegen der elektronischen Bauteile schnell und sicher durchgeführt werden kann. Durch die Überwachung mittels dem optischen System sowohl der Aufnahmeposition als auch der Montagepositionen können Informationen bereitgestellt werden, welche ein schnelles und zielsicheres Aufnahmen der elektronischen Bauteile aus dem ersten Bauteilereservoir ermöglichen und darüber hinaus auch ein schnelles und zielsicheres Ablegen bzw. Montieren des transportierten elektronischen Bauteils in dem zweiten Bauteilereservoir gewährleistet. Der gesamte Ablauf des Aufnehmens, Transportierens und Montierens der elektronischen Bauteile kann mittels der erfindungsgemäßen Vorrichtung optimiert werden.

Es kann vorgesehen sein, dass das optische System derart ausgebildet ist, dass festgelegt wird, an welcher Position des ersten Bauteilereservoirs ein elektronisches Bauteil in einem nachfolgenden Aufnahmevorgang aus dem ersten Bauteilereservoir durch die Aufnahme- und Transporteinheit ausgewählt wird und insbesondere abhängig davon eine Montageposition in dem zweiten Bauteilereservoir ausgewählt wird. Dadurch kann ermöglicht werden, dass für einen nachfolgenden Aufnahmevorgang bereits bekannt ist, an welcher Position das entsprechende Bauteil aus dem ersten Bauteilereservoir zu entnehmen ist. Des Weiteren kann bereits vorab eine entsprechende Information dahingehend ermittelt werden, an welcher Montageposition das aufzunehmende oder bereits aufgenommene elektronische Bauelement im zweiten Bauteilereservoir abgelegt bzw. montiert wird.

Es kann auch vorgesehen sein, dass das optische System derart ausgebildet ist, dass erkannt wird, welches elektronische Bauteil in einer als nächstes zu besetzenden Montageposition in dem zweiten Bauteilereservoir erforderlich ist und abhängig davon eine Aufnahmeposition des Bauteils aus dem ersten Bauteilereservoir-ermittelbar ist. Diesbezüglich kann erreicht werden, dass anhand der gewonnenen Informationen über die Montageposition eine entsprechende Auswahl der Aufnahmeposition bzw. des bereitgestellten elektronischen Bauteils im ersten Bauteilereservoir getätigt wird.

Es ist durch die erfindungsgemäße Vorrichtung somit gewährleistet, dass anhand von Informationen über die nächste Aufnahmeposition bzw. das an dieser Aufnahmeposition bereitgestellte elektronische Bauteil eine entsprechende Montageposition im zweiten Bauteilereservoir ausgewählt wird. Es kann jedoch, wie erläutert, ebenso vorgesehen sein, dass zunächst Informationen über die als nächstes zu besetzende Montageposition generiert werden und anhand dieser Informationen eine Aufnahmeposition im ersten Bauteilereservoir ausgewählt wird, an der ein für die spezielle Montageposition passendes elektronisches Bauteil bereitgestellt ist. Die erfindungsgemäße Vorrichtung ermöglicht dadurch eine sehr variable und flexible Informationsverarbeitung im Hinblick auf die Aufnahme und die Montage bzw. Ablage der elektronischen Bauteile aus dem ersten Bauteilereservoir bzw. in das zweite Bauteilereservoir, wodurch der gesamte Ablauf von Aufnahme bis Montage optimiert werden kann.

Es kann auch vorgesehen sein, dass das optische System ortsfest und die Aufnahme- und Transporteinheit bewegbar an einem Halteelement, insbesondere einem säulenförmigen Halteelement, angeordnet sind. Es kann vorgesehen sein, dass das optische System zumindest zwei Kameras, insbesondere CCD-Kameras aufweist. In vorteilhafter Weise sind die beiden Kameras derart angeordnet, dass die optische Achse der ersten Kamera senkrecht auf die Oberfläche des ersten Bauteilereservoirs gerichtet ist und die optische Achse der zweiten Kamera senkrecht auf die Oberfläche des zweiten Bauteilereservoirs gerichtet ist. Dadurch kann erreicht werden, dass sowohl das erste Bauteilereservoir als auch das zweite Bauteilereservoir in optimaler Weise im Hinblick auf die Aufnahmepositionen bzw. die Montagepositionen der entsprechenden elektronischen Bauteile überwacht werden, in dem für jedes Bauteilereservoir eine eigene Kamera bereitgestellt ist. Darüber hinaus ermöglich die im Wesentlichen senkrechte Anordnung der optischen Achse auf die Oberfläche der Bauteilereservoire, dass stets eine optimale Beobachtungsposition gegeben ist, auch dann wenn das erste und/oder das zweite Bauteilereservoir bewegt werden, insbesondere in einer Ebene senkrecht zur optischen Achse der entsprechend zugeordneten Kameras bewegt werden.

Die Aufnahme- und Transporteinheit weist in bevorzugter Weise Stege auf, an denen jeweils zumindest ein Aufnahme- und Montagewerkzeug angeordnet ist. Zwischen zwei benachbarten Stegen sind in vorteilhafter Weise Aussparungen ausgebildet. In vorteilhafter Weise ist die Aufnahme- und Transporteinheit derart an dem Halteelement angeordnet, dass bei einer Bewegung der Aufnahme- und Transporteinheit ein Aufnahme- und Montagewerkzeug zeitweise in der optischen Achse der ersten Kamera zwischen der ersten Kamera und dem ersten Bauteilereservoir und zeitweise in der optischen Achse der zweiten Kamera zwischen der zweiten Kamera und dem zweiten Bauteilereservoir positionierbar ist.

Darüber hinaus kann in vorteilhafter Weise vorgesehen sein, dass die Aussparungen zwischen zwei benachbarten Stegen derart ausgebildet sind, dass bei einer Bewegung der Aufnahme- und Transporteinheit die optischen Achsen der beiden Kameras zeitweise freigegeben sind. Insbesondere bei einer Rotation um die Achse des Halteelements kann dadurch eine Bewegung erzielt werden, bei der ein Aufnahme- und Montagewerkzeug an einem Steg bei einer vollständigen Umdrehung sowohl einmal in der optischen Achse der ersten Kamera und einmal in der optischen Achse der zweiten Kamera angeordnet ist. Die Stege sind derart ausgebildet, dass beim Heraustreten eines Aufnahme- und Montagewerkzeugs aus einer optischen Achse einer Kamera unmittelbar der Übergang in eine Aussparung der Aufnahme- und Transporteinheit erfolgt. Dies bedeutet somit, dass der optische Weg zwischen der Kamera und einem entsprechend zugeordneten Bauteilereservoir so lange blockiert ist, bis ein Aufnahme- und Montagewerkzeug vorbeigeführt ist. Die optische Achse wird unmittelbar nach dem Heraustreten eines derartigen Aufnahme- und Montagewerkzeugs aus der optischen Achse der zugeordneten Kamera freigegeben, da die Aussparungen der Aufnahme- und Transporteinheit derart ausgebildet sind, dass sie unmittelbar an die Ausmaße von benachbarten, an benachbarten Stegen angeordneten, Aufnahme- und Montagewerkzeuge ausgebildet sind. Somit ist die optische Achse einer Kamera nur dann blockiert, wenn ein Aufnahme- und Montagewerkzeug während einer Rotationsbewegung um die Achse des Halteelements die optische Achse der Kamera durchstreicht. Somit kann in optimaler Weise gewährleistet werden, dass die optischen Achsen der Kameras längst möglich freigegeben sind und dadurch ein möglichst langes Überwachen und Beobachten der Oberflächen der entsprechenden Bauteilereservoire durchgeführt werden kann. Diesbezüglich kann erreicht werden, dass möglichst viele und genaue Informationen durch die Kameras über die Aufnahmepositionen und Montagepositionen erhalten werden können.

Es kann vorgesehen sein, dass die Kameras und die Aufnahme- und Montagewerkzeuge mit einem Winkel α gegenüber der Achse des Halteelements geneigt sind. Die Neigung mit einem entsprechenden Winkel α erfolgt dabei bevorzugt derart, dass die optische Achse der Kamera senkrecht zur Ebene in der das zugeordnete Bauteilereservoir angeordnet ist. Es kann vorgesehen sein, dass das erste Bauteilereservoir in einer Ebene senkrecht zur optischen Achse der ersten Kamera bewegbar ist und das zweite Bauteilereservoir in einer Ebene senkrecht zur optischen Achse der zweiten Kamera bewegbar ist. Es kann auch vorgesehen sein, dass das optische System eine dritte Kamera aufweist, welche zum Überwachen einer Relativposition des aus dem ersten Bauteilereservoir aufgenommenen Bauteils in dem Aufnahme- und Montagewerkzeug ausgebildet ist.

In einer vorteilhaften Ausführung kann vorgesehen sein, dass die bei den ersten Kameras in einer Ebene angeordnet sind und die vier Stege der Aufnahme- und Transporteinheit jeweils im 90°-Winkel zueinander angeordnet sind.

Ein erfindungsgemäßes Verfahren zur Aufnahme und Übergabe eines elektronischen Bauteils auf ein Bauteilereservoir, insbesondere mit einer vollautomatischen Aufnahme- und Übergabevorrichtung zur Herstellung mikrosystemtechnischer Produkte, ist derart ausgelegt, dass in einem auf einem ersten Montagetisch angeordneten ersten Bauteilereservoir elektronische Bauteile für ein auf einem zweiten Montagetisch angeordneten zweiten Bauteilereservoir bereitgestellt werden. Die bereitgestellten elektronischen Bauteile werden mittels einer Aufnahme- und Transporteinheit aus dem ersten Bauteilereservoir aufgenommen und zum zweiten Bauteilereservoir transportiert und in dem zweiten Bauteilereservoir montiert. Die Aufnahme des elektronischen Bauteils aus einer Aufnahmeposition des ersten Bauteilereservoirs und die Montage dieses elektronischen Bauteils an einer Montageposition im zweiten Bauteilereservoir wird durch ein optisches System überwacht. Dadurch kann erreicht werden, dass die Bauteile schnell und präzise an ihren entsprechenden Positionen aufgenommen und montiert werden können. Darüber hinaus kann eine erhöhte Durchsatzzahl erzielt werden, wodurch sich die Montagekosten für die Bauteile reduzieren lassen.

Weitere vorteilhafte Ausgestaltungen des erfindungsgemäßen Verfahren sind in den Unteransprüche angegeben.

Nachfolgend wird ein Ausführungsbeispiel der Erfindung anhand schematischer Zeichnungen näher erläutert. Es zeigen:
- Figur 1: Eine perspektivische Darstellung einer erfindungsgemäßen Vorrichtung; und
- Figur 2: eine Schnittdarstellung einer erfindungsgemäßen Vorrichtung.

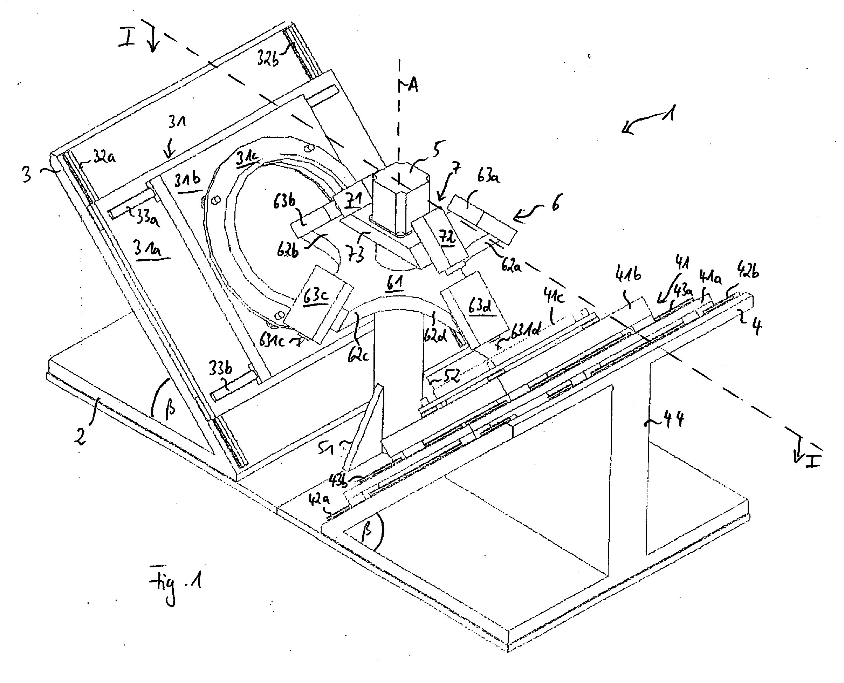

Eine erfindungsgemäße Vorrichtung zur Montage von elektronischen Bauteilen ist in Figur 1 gezeigt. Die Vorrichtung 1 zeigt eine Grundplatte 2, welche Bereiche 3 und 4 aufweist, die schräg nach außen und oben hin orientiert sind. Die beiden Teilbereiche 3 und 4 sind dabei jeweils um einen gleichen Winkel β gegenüber der horizontal angeordneten Platte 2 geneigt. Auf dem ersten Teilbereich 3 ist eine Montagevorrichtung 31 bewegbar angeordnet, welcher über Schienen 32a und 32b entlang der Schrägfläche des Teilbereichs 3 bewegt werden kann. Der Schlitten 31 weist dazu einen ersten Teil 31a auf, welcher an seiner Unterseite entsprechende Führungselemente aufweist, die in die Schienen 32a und 32b zur Führung entlang dieser Schienen 32a und 32b eingreifen. An der den Schienen 32a und 32b gegenüberliegenden Seite des Elements 31 a sind ebenfalls zwei weitere Schienen 33a und 33b im Wesentlichen senkrecht zu den ersten beiden Schienen 32a und 32b angeordnet. Mit entsprechenden Führungselementen, welche an der Unterseite des Elements 31b des Schlittens 31 angeordnet sind, und welche zur Führung des Teils 31b in die Schienen 33a und 33b eingreifen.

Auf dem Teil 31b des Schlittens 31 ist ein Montagetisch 31c angeordnet, welcher im Ausführungsbeispiel als Kreisring ausgebildet ist. Der Kreisring 31c ist über Abstandselemente beabstandet zu dem Teil 31b angeordnet und über diese Abstandselemente mit dem Teil 31b fest verbunden. Auf dem Montagetisch 31c ist ein erstes Bauteilereservoir (nicht dargestellt) angeordnet, welches im Ausführungsbeispiel als Wafer ausgebildet ist. Das erste Bauteilereservoir, welches fest auf dem Montagetisch 31c befestigt ist, kann durch die Schienen 32a und 32b sowie über die Schienen 33a und 33b und der entsprechenden Bewegung der Elemente 31a und 31b in einer Ebene parallel zu dem schrägen Teilbereich 3 bewegt werden.

In analoger Weise ist auf dem Teilbereich 4 ebenfalls ein Schlitten 41 angeordnet, welcher in analoger Weise zum Schlitten 31 ausgebildet ist. Auch der Schlitten 41 weist Teile 41a und 41b auf, welche mit entsprechenden Schienen 42a und 42b entlang der Schrägfläche des Teilbereichs 4 und parallel dazu nach oben und nach unten verschoben werden können. Diesbezüglich weist der Bereich 41a des Schlittens 41 Führungselemente an seiner Unterseite auf, welche in die Schienen 42a und 42b zur Führung eingreifen. In analoger Weise zur Ausbildung des Schlittens 31 weist der Schlitten 41 an der Oberseite des Teils 41a, Schienen 43a und 43b auf, welche im Wesentlichen senkrecht zu den Führungsschienen 42a und 42b angeordnet sind. Führungselemente an der Unterseite des Teils 41b des Schlittens 41 greifen in diese Führungsschienen 43a und 43b ein. An der diesen Führungselementen gegenüberliegenden Seite des Teiles 41b ist in entsprechender Weise ein Montagetisch 41 c mittels Abstandselemente fest an dem Teil 41b befestigt. An der Oberfläche des Montagetisches 41c ist ein zweites Bauteilereservoir (nicht dargestellt) angeordnet. Auch dieses zweite Bauteilereservoir ist als Wafer im Ausführungsbeispiel ausgebildet.

Wie aus der Darstellung in Figur 1 zu erkennen ist, ist der Teilbereich 4 über ein Stützelement 44 gegenüber der Bodenplatte 2 abgestützt. In entsprechender Weise ist eine derartige Abstützung auch zwischen dem Teilbereich 3 und der Bodenplatte 2 der Vorrichtung 1 ausgebildet. Zwischen den Teilbereichen 3 und 4 der Vorrichtung 1 ist ein Halteelement 5 angeordnet, welches im Ausführungsbeispiel säulenartig ausgebildet ist und mittig zwischen den beiden Teilbereichen 3 und 4 angeordnet ist. Das Halteelement 5 ragt im Wesentlichen senkrecht aus dem Bodenelement 2 heraus und ist über Stützflanken 51 und 52 gegenüber der Bodenplatte 2 abgestützt. An dem Halteelement 5 ist eine Aufnahme- und Transpsorteinheit 6 bewegbar angeordnet. Die Aufnahme- und Transporteinheit 6 weist eine im Wesentlichen parallel zur Bodenplatte 2 ausgebildete sternförmig geartete Platte 61 auf. Die sternförmige Platte 61 umfasst im Ausführungsbeispiel vier Stege 62a bis 62d, welche im Ausführungsbeispiel im Winkel von 90° zueinander angeordnet sind. Die freien Enden der Stege 62a bis 62d weisen abgeschrägte Flächen auf, an denen jeweils ein Aufnahme- und Montagewerkzeug 63a bis 63d angeordnet ist. Die Aufnahme- und Montagewerkzeuge 63a bis 63d sind an den Schrägflächen der Stege 62a bis 62d fest angeordnet. Die Schrägflächen der Stege 62a bis 62d weisen dabei eine derartige Neigung auf, dass die Aufnahmeelemente 631a (nicht dargestellt), 631b (nicht dargestellt), 631c und 631d im Wesentlichen senkrecht zur Fläche der Montagetische 31c und 41c bzw. der darauf angeordneten ersten bzw. zweiten Bauteilereservoire orientiert sind, wenn sie jeweils in Richtung zu einem der Bauteilereservoire zeigen.

Darüber hinaus umfasst die Vorrichtung 1 ein optisches System 7, welches eine erste Kamera 71 und eine zweite Kamera 72 aufweist. Die beiden Kameras 71, 72 sind ortsfest mit dem Halteelement 5 verbunden und an einem Auflageelement 73 angeordnet. Das Auflageelement 73 weist zwei gegenüberliegende Schrägflächen auf, wobei an der ersten Schrägfläche die erste Kamera 71 und an der zweiten Schrägfläche die zweite Kamera 72 positioniert ist. Die beiden Kameras 71, 72 sind dabei derart angeordnet, dass sie in einer Ebene, welche senkrecht zur Bodenplatte 2 orientiert ist, angeordnet sind und im Ausführungsbeispiel mit ihrer optischen Achse senkrecht auf den jeweils zugeordneten Bauteilereservoiren bzw. den dafür vorgesehen Montagetischen 31 c und 41 c orientiert sind. Die Schrägflächen des Elements 73 sind dabei mit einem derartigen Winkel bzw. mit einer derartigen Neigung versehen, welche den Schrägflächen bzw. den Neigungen der Stege 62a bis 62d der Aufnahme- und Transporteinheit 6 entspricht. Die Aufnahme- und Transporteinheit 6 weist in ihrem Element 61 Aussparungen auf, welche im Ausführungsbeispiel als konkav nach innen gewölbte Bereiche zwischen zwei benachbarten Stegen ausgebildet sind. Die konkaven Aussparungen sind dabei derart ausgebildet, dass bei einem Drehen des Elements 61 um die Längsachse A des Halteelements 5 immer abwechselnd ein Aufnahme- und Montagewerkzeug 63a bis 63d in die optische Achse zwischen den Kameras 71 und 72 eintritt und die optische Achse einer Kamera 71 bzw. 72 versperrt. Bewegt sich ein derartiges Aufnahme- und Montagewerkzeug 63a bis 63d durch eine Rotation des Elements 61 weiter und damit aus dem Bereich der optischen Achse einer Kamera 71 bzw. 72 heraus, so wird unmittelbar die optische Achse der betrachteten Kamera 71 bzw. 72 freigegeben, da die jeweiligen konkav ausgekrümmten Aussparungen in dem Element 61 derart zurückversetzt sind, dass der Strahlengang zwischen einer Kamera 71 bzw. 72 und dem entsprechend zugeordneten ersten bzw. zweiten Bauteilereservoir freigegeben ist bzw. kein Hindernis im optischen Strahlengang zwischen der Kamera 71, 72 und dem entsprechend zu geordneten Bauteilereservoir angeordnet ist.

Die Funktionsweise der erfindungsgemäßen Vorrichtung wird nachfolgend noch näher erläutert. Als Ausgangsposition ist vorgesehen, dass das Element 61 der Aufnahme- und Transporteinheit 6 derart angeordnet ist, dass der optische Strahlengang bzw. die optische Achse der ersten Kamera 71 und auch die optische Achse bzw. der optische Strahlengang der Kamera 72 freigegeben ist. Dies bedeutet, dass die Aussparungen des Elements 61 im Bereich der optischen Achsen der Kamera 71 und der Kamera 72 angeordnet sind. Durch die Kamera 71 wird auf dem ersten Bauteilereservoir, in dem elektronische Bauteile für das zweite Bauteilereservoir bereitgestellt sind, eine Aufnahmeposition eines ersten Bauteils detektiert. Die beiden Kameras 71 und 72 sind dabei mit einer entsprechenden Auswerte- und Steuereinrichtung verbunden, mit welcher die durch die beiden Kameras generierten Informationen ausgewertet und eine entsprechende Steuerung der Vorrichtung 1 erfolgen kann. Mittels dieser Steuereinheit kann auch die relative Bewegung der Montagetische 31c und 41c bzw. der darauf angeordneten Bauteilereservoire relativ zu den beiden Kameras 71 und 72 gesteuert werden. Es kann jedoch auch vorgesehen sein, dass die Steuerung der Schlitten 31 und 41 bzw. deren Elemente 31a, 31b und 31c sowie 41a, 41b und 41c über separate Steuereinheiten erfolgt. Die mittels der ersten Kamera 71 generierten Informationen im Hinblick auf eine Aufnahmeposition im ersten Bauteilereservoir wird an die Steuereinheit weitergegeben, und abhängig davon kann vorgesehen sein, dass mittels der zweiten Kamera 72 eine entsprechende Montageposition auf dem zweiten Bauteilereservoir durchgeführt wird. Überstreicht nun in der nachfolgenden Rotationsbewegung des Elements 61 das auf die in Bewegungsrichtung folgende Aufnahme- und Montagewerkzeug 63a bis 63d die optische Achse der Kamera 71, so wird das an der ausgewählten Aufnahmeposition platzierte elektronische Bauteil mittels dem zugeordneten Aufnahmeelement 631 a bis 631 d aufgenommen. Es sei angemerkt, dass die Aufnahmeelemente 631a bis 631d in allen drei Raumdimensionen bewegbar in dem zugeordneten Aufnahme- und Montagewerkzeug 63a bis 63d angeordnet sind. Hat das entsprechende Aufnahme- und Montagewerkzeug 63a bis 63d das aufzunehmende elektronische Bauteil aus dem ersten Bauteilereservoir aufgenommen, erfolgt eine weitere Bewegung bzw. eine weitere Rotation um die Achse A des Halteelements 5 in Richtung zum zweiten Bauteilereservoir hin. Wie in Figur 1 zu erkennen ist, wird die Aufnahme eines weiteren elektronischen Bauteils aus dem ersten Bauteilereservoir bereits durchgeführt, wenn das mit dem ersten Bauteil in Richtung zum zweiten Bauteilereservoir hin bewegte Aufnahme- und Montagewerkzeug 63a bis 63d erst die Hälfte dieses Weges zurückgelegt hat. Eine mittels der Kamera 71 durchgeführte Überwachung und Beobachtung der Oberfläche des ersten Bauteilereservoirs erfolgt immer dann, wenn die Aussparungen des Elements 61 an der optischen Achse der Kamera 71 vorbeilaufen. Wie aus der Figur 1 weiter zu erkennen ist, erreicht das das erste elektronische Bauteil aufgenommene Aufnahme- und Montagewerkzeug 63a bis 63d die optische Achse der zweiten Kamera 72, welche über die Steuereinheit die für das erste elektronische Bauteil vorgesehene Montageposition auf dem zweiten Bauteilereservoir erkennt. Die das erste Bauteil aufgenommene und transportierende Aufnahme- und Montagewerkzeug 63a bis 63d legt dann das erste elektronische Bauteil an der entsprechende Montageposition zur Montage auf dem zweiten Bauteilereservoir ab. Wie aus der speziellen Anordnung im Ausführungsbeispiel gemäß Figur 1 der Aufnahme- und Montagewerkzeuge 63a bis 63d zu erkennen ist, wird durch die gegenüberliegende Anordnung stets durch eines der Aufnahme- und Montagewerkzeuge 63a bis 63d an einer ausgewählten Aufnahmeposition ein elektronisches Bauteil aus dem ersten Bauteilereservoir aufgenommen und im Wesentlichen gleichzeitig dazu ein anderes elektronisches Bauteil, welches zwei Schritte vorher aus dem ersten Bauteilereservoir und einer entsprechenden Aufnahmeposition entnommen wurde, in der ausgewählten und überwachten Montageposition im zweiten Bauteilereservoir platziert.

Es kann auch vorgesehen sein, dass zunächst über die zweite Kamera 72 eine Montageposition für ein als nächstes aus dem ersten Bauteilereservoir aufzunehmenden elektronischen Bauteil ausgewählt wird und anhand dieser Information eine entsprechende Aufnahmeposition mit einem entsprechenden dort angeordneten elektronischen Bauteil in dem ersten Bauteilereservoir gesucht wird und mittels der ersten Kamera 71 detektiert bzw. ausgewählt und überwacht wird.

Es kann des Weiteren vorgesehen sein, dass eine dritte Kamera (nicht dargestellt) derart angeordnet ist, dass die Relativposition des an einem Aufnahme- und Montagewerkzeugs 63a bis 63d aufgenommenen elektronischen Bauteils feststellbar ist und für eine nachfolgende Aufnahme eines Bauteils und/oder für eine entsprechende Positionierung bzw. Ablage dieses Bauelements oder eines nachfolgenden oder vorhergehenden Bauelements verwendet wird.

Es kann auch vorgesehen sein, dass die Anzahl der Aufnahme- und Montagewerkzeuge 63a bis 63d größer oder kleiner der im Ausführungsbeispiel gezeigten Anzahl ist. Es können in entsprechender Weise auch mehrere Kameras 71 bis 72 sowie mehrere erste als auch zweite Bauteilereservoire vorgesehen sein.

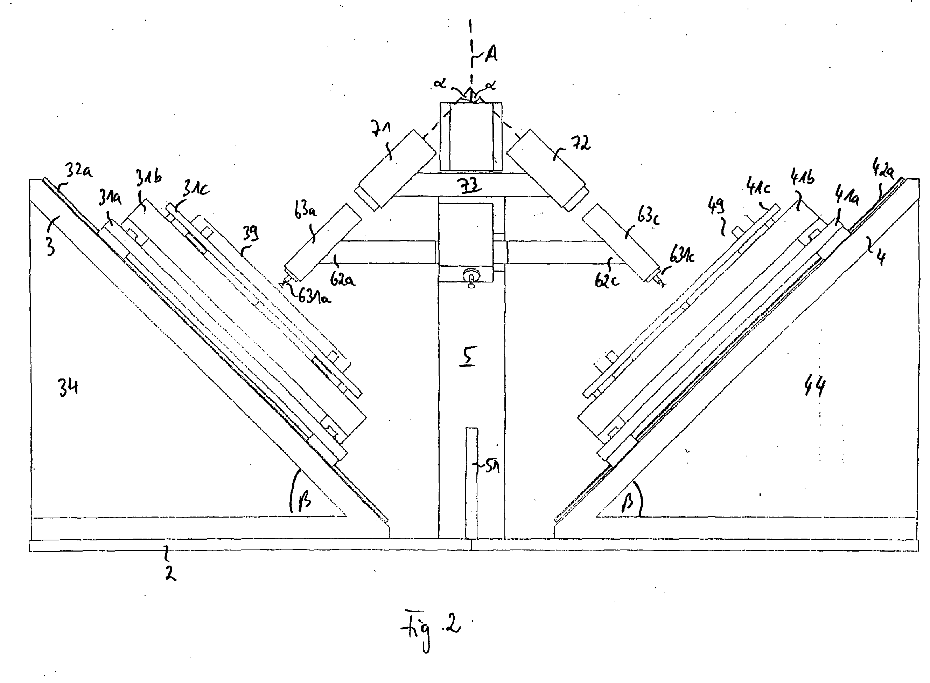

In Figur 2 ist eine Schnittdarstellung der erfindungsgemäßen Vorrichtung entlang der Schnittlinie 11 gemäß Figur 1 gezeigt. In beiden Figuren sind gleiche oder funktionsgleiche Elemente mit gleichen Bezugszeichen versehen. Wie aus der Darstellung in Figur 2 zu erkennen ist, ist die optische Achse der ersten Kamera 71 senkrecht auf die Ebene des ersten Bauteilereservoirs 39 gerichtet. In der gezeigten Ausführungs in Figur 2 ist das Aufnahme- und Montagewerkzeug 63a in einer Position, in der es die optische Achse der ersten Kamera 71 zum ersten Bauteilereservoir 39 blockiert. Das Aufnahme- und Montagewerkzeug 63a nimmt aus einer entsprechend ausgewählten Aufnahmeposition ein elektronisches Bauteil aus dem ersten Bauteilereservoir 39 auf. In entsprechender Weise ist in der senkrecht auf das zweite Bauteilereservoir orientierten optischen Achse der zweiten Kamera 72 das Aufnahme- und Montagewerkzeug 63c angeordnet. Das Aufnahme- und Montagewerkzeug 63c setzt ein elektronisches Bauteil an einer entsprechend ausgewählten Montageposition auf dem zweiten Bauteilereservoir ab. Die Bauteile werden dabei mit den Elementen 631a und 631c gehalten.

## Patentansprüche

1. Vorrichtung zur Aufnahme und Übergabe eines elektronischen Bauteils, insbesondere eine vollautomatische Aufnahme- und Übergabevorrichtung zur Herstellung mikrosystemtechnischer Produkte sowie für Montageaufgaben in der Halbleiterindustrie, mit
- einem ersten Bauteilereservoir (39), welches auf einem ersten Montagetisch (31 c) angeordnet ist, und
- einem zweiten Bauteilereservoir (49), welches auf einem zweiten Montagetisch (41 c) angeordnet ist, wobei in dem ersten Bauteilereservoir (39) elektronische Bauteile für das zweite Bauteilereservoir (49) bereitgestellt sind, und
- die Vorrichtung eine Aufnahme- und Transporteinheit (6) zur Aufnahme eines elektronischen Bauteils aus dem ersten Bauteilereservoir (39) und zum Transport des elektronischen Bauteils von dem ersten Bauteilereservoir (39) zum zweiten Bauteilereservoir (49) aufweist, und
- ein optisches System (7) umfasst, welches zur Überwachung zumindest einer Aufnahmeposition eines elektronischen Bauteils aus dem ersten Bauteilereservoir (39) und zur Überwachung zumindest einer Montageposition des aufgenommenen elektronischen Bauteils in dem zweiten Bauteilereservoir (49) ausgebildet ist.

2. Vorrichtung nach Anspruch 1,
**dadurch gekennzeichnet,dass**
das optische System (7) derart ausgebildet ist, dass festgelegt wird, an welcher Position des ersten Bauteilereservoirs (39) ein Bauteil in einem nachfolgenden Aufnahmevorgang aus dem ersten Bauteilereservoir (39) durch die Aufnahme- und Transporteinheit (6) ausgewählt wird und eine Montageposition, insbesondere abhängig von der Aufnahmeposition, in dem zweiten Bauteilereservoir (49) ausgewählt wird.

3. Vorrichtung nach Anspruch 1,
**dadurch gekennzeichnet,dass**
das optische System (7) derart ausgebildet ist, dass erkannt wird, welches Bauteil in einer als nächstes zu besetzenden Montageposition in dem zweiten Bauteilereservoir (49) erforderlich ist und eine Aufnahmeposition des Bauteils, insbesondere abhängig von der Montageposition, aus dem ersten Bauteilereservoir (39) ermittelbar ist.

4. Vorrichtung nach einem der vorhergehenden Ansprüche,
**dadurch gekennzeichnet,dass**
das optische System (7) ortsfest und die Aufnahme- und Transportvorrichtung (6) bewegbar an einem Halteelement (5), insbesondere einem säulenförmigen Haltelement, angeordnet sind.

5. Vorrichtung nach einem der vorhergehenden Ansprüche,
**dadurch gekennzeichnet,dass**
das optische System (7) zumindest zwei Kameras (71, 72), insbesondere CCD-Kameras, aufweist, wobei die optische Achse der ersten Kamera (71) senkrecht auf die Oberfläche des ersten Bauteilereservoirs (39) gerichtet ist und die optische Achse der zweiten Kamera (72) senkrecht auf die Oberfläche des zweiten Bauteilereservoirs (49) gerichtet ist.

6. Vorrichtung nach Anspruch 4 und 5,
**dadurch gekennzeichnet,dass**
die Aufnahme- und Transporteinheit (6) Stege (62a bis 62d) aufweist, an denen jeweils zumindest ein Aufnahme- und Montagewerkzeug (63a bis 63d) angeordnet ist, wobei jeweils zwischen zwei Stegen (62a bis 62d) Aussparungen ausgebildet sind.

7. Vorrichtung nach Anspruch 6,
**dadurch gekennzeichnet,dass**
die Aufnahme- und Transporteinheit (6) derart an dem Halteelement (5) angeordnet ist, dass bei einer Bewegung der Aufnahme- und Transporteinheit (6), insbesondere einer Rotation um die Achse (A) des Halteelements (5), ein Aufnahme- und Montagewerkzeug (63a bis 63d) zeitweise in der optischen Achse der ersten Kamera (71) zwischen der ersten Kamera (71) und dem ersten Bauteilereservoir (39) und zeitweise in der optischen Achse der zweiten Kamera (72) zwischen der zweiten Kamera (72) und dem zweiten Bauteilereservoir (49) positionierbar ist.

8. Vorrichtung nach Anspruch 6 oder 7,
**dadurch gekennzeichnet,dass**
die Aussparungen zwischen zwei benachbarten Stegen (62a bis 62d) derart ausgebildet sind, dass bei einer Bewegung der Aufnahme- und Transporteinheit (6), insbesondere einer Rotation um die Achse (A) des Halteelements (5), die optischen Achsen der Kameras (71, 72) zeitweise freigegeben sind.

9. Vorrichtung nach einem der Ansprüche 6 bis 8,
**dadurch gekennzeichnet,dass**
die Kameras (71, 72) und die Aufnahme- und Montagewerkzeuge (63a bis 63d) mit einem Winkel α gegenüber der Achse (A) des Halteelements (5) geneigt sind.

10. Vorrichtung nach Anspruch 5,
**dadurch gekennzeichnet,dass**
das erste Bauteilereservoir (39) in einer Ebene senkrecht zur optischen Achse der ersten Kamera (71) bewegbar ist und das zweite Bauteilereservoir (49) in einer Ebene senkrecht zur optischen Achse der zweiten Kamera (72) bewegbar ist.

11. Vorrichtung nach einem der vorhergehenden Ansprüche,
**dadurch gekennzeichnet,dass**
das optische System (7) eine dritte Kamera aufweist, welche zum Überwachen einer Relativposition des aus dem ersten Bauteilereservoir (39) aufgenommenen Bauteils in dem Aufnahme- und Montagewerkzeug (63a bis 63d) ausgebildet ist.

12. Vorrichtung nach einem der Ansprüche 5 oder 6,
**dadurch gekennzeichnet,dass** die Kameras (71, 72) in einer Ebene und die vier Stege (62a bis 62d) jeweils im 90°-Winkel zueinander angeordnet sind.

13. Verfahren zur Aufnahme und Übergabe eines elektronischen Bauteils, insbesondere mit einer vollautomatische Aufnahme- und Übergabevorrichtung zur Herstellung mikrosystemtechnischer Produkte, bei dem
- in einem auf einem ersten Montagetisch (31 c) angeordneten ersten Bauteilereservoir (39) elektronische Bauteile für ein auf einem zweiten Montagetisch (41 c) angeordnetes zweites Bauteilereservoir (49) bereitgestellt werden,
- zumindest ein bereitgestelltes elektronischen Bauteil mittels einer Aufnahme- und Transporteinheit (6) aus dem ersten Bauteilereservoir (39) aufgenommen wird und zum zweiten Bauteilereservoir (49) transportiert und in dem zweiten Bauteilereservoir (49) montiert wird, wobei
- die Aufnahme des elektronischen Bauteils aus einer Aufnahmeposition des ersten Bauteilereservoirs (39) und die Montage dieses elektronischen Bauteils an einer Montageposition im zweiten Bauteilereservoir (49) durch ein optisches System (7) überwacht wird.

14. Verfahren nach Anspruch 13,
**dadurch gekennzeichnet,dass**
mittels dem optischen System (7) festgelegt wird an welcher Position des ersten Bauteilereservoirs (39) ein Bauteil in einem nachfolgenden Aufnahmevorgang aus dem ersten Bauteilereservoir (39) durch die Aufnahme- und Transporteinheit (6) ausgewählt wird und eine Montageposition in dem zweiten Bauteilereservoir (49), insbesondere abhängig von der Aufnahmeposition, ausgewählt wird.

15. Verfahren nach Anspruch 13,
**dadurch gekennzeichnet,dass**
mittels dem optische System (7) erkannt wird, welches Bauteil in einer als nächstes zu besetzenden Montageposition in dem zweiten Bauteilereservoir (49) erforderlich ist und eine Aufnahmeposition des Bauteils aus dem ersten Bauteilereservoir (49), insbesondere abhängig von der Montageposition, ermittelt wird.

16. Verfahren nach einem der Ansprüche 13 bis 15,
**dadurch gekennzeichnet,dass**
bei einer Bewegung der Aufnahme- und Transporteinheit (6), insbesondere einer Rotation um die Achse (A) eines Halteelements (5) an dem die Aufnahme- und Transporteinheit (6) bewegbar angeordnet ist, zumindest ein Aufnahme- und Montagewerkzeug (63a bis 63 d) der Aufnahme- und Transporteinheit (6) zeitweise in der optischen Achse der ersten Kamera (71) zwischen der ersten Kamera (71) und dem ersten Bauteilereservoir (39) und zeitweise in der optischen Achse der zweiten Kamera (72) zwischen der zweiten Kamera (72) und dem zweiten Bauteilereservoir (49) positioniert wird.

17. Verfahren nach einem der Ansprüche 13 bis 16,
**dadurch gekennzeichnet,dass**
bei einer Bewegung der Aufnahme- und Transporteinheit (6), insbesondere einer Rotation um die Achse (A) des Halteelements (5) an dem die Aufnahme- und Transporteinheit (6) bewegbar angeordnet ist, die optischen Achsen der Kameras (71, 72) durch Aussparungen zwischen zwei benachbarten Stegen (62a bis 62d) in der Aufnahme- und Transporteinheit (6) zeitweise freigegeben werden.
